# FASCICULE DE BREVET EUROPEEN

(11) **EP 1 520 669 B1**
(45) Date de publication et mention de la délivrance du brevet: **16.08.2006**
(21) Numéro de dépôt: 04104612.9
(22) Date de dépôt: 23.09.2004
(51) Int. Cl.: B26F 3/00, H01L 21/00, B26D 7/14, B32B 37/00

(54) **Procédé de séparation de plaques collées entre elles pour constituer une structure empilée**
Verfahren zum Trennen von Platten, die miteinander geklebt sind und eine gestapelte Struktur bilden
A method for separating plates which are bonded with each other and form a piled structure

(30) Priorité: 30.09.2003 FR 0350619
(43) Date de publication de la demande: 06.04.2005
(73) Titulaire: COMMISSARIAT A L'ENERGIE ATOMIQUE, 75752 Paris Cédex 15 (FR)
(72) Inventeur: Moriceau, Hubert, 38120 Saint Egreve (FR); Fournel, Franck, 38430 Moirans (FR); Aspar, Bernard, 38140 Rives (FR)
(74) Mandataire: Poulin, Gérard

(56) Documents cités:
- DE-A- 1 908 597
- US-A- 5 863 375
- PATENT ABSTRACTS OF JAPAN vol. 010, no. 343 (E-456), 19 novembre 1986 (1986-11-19) & JP 61 145839 A (TOSHIBA CORP), 3 juillet 1986 (1986-07-03)

## Description

### DOMAINE TECHNIQUE

L'invention concerne un procédé de séparation de plaques collées entre elles pour constituer une structure empilée. Elle se rapporte en particulier aux procédés d'obtention d'une couche mince semiconductrice.

La structure à séparer peut être constituée par l'empilement d'un même matériau ou de plusieurs matériaux collés (par adhésion moléculaire ou par matériau d'appoint). Elle peut aussi être constituée par au moins un matériau dans lequel on a induit la fragilisation d'une zone.

### ETAT DE LA TECHNIQUE ANTERIEURE

L'obtention d'une couche mince semiconductrice implique souvent une opération de séparation entre cette couche mince et un support sur lequel elle est collée. Plusieurs techniques de séparation ont été développées à cet effet.

Une première approche consiste à propager une fracture d'ouverture dans une structure constituée de deux plaques collées entre elles.

On peut citer la technique de mesure présentée en particulier par W.P. Maszara et al. dans l'article « Bonding of silicon wafers for silicon-on-insulator » (J. Appl. Phys. 64(10), 15 novembre 1998), dite de la propagation d'une fracture d'ouverture (« Crack Opening Method » en anglais). Cette méthode consiste en particulier à introduire une lame au bord d'une structure constituée de deux plaques collées et dans leur plan de collage. Elle a été développée en particulier pour caractériser des collages par adhésion moléculaire. Cette méthode n'enseigne pas la manière de séparer deux plaques. Au contraire, elle met l'accent sur l'arrêt de l'onde d'ouverture et la nécessité de déterminer la distance d'arrêt de cette onde, sachant que l'ouverture est provoquée par l'insertion d'une lame d'épaisseur constante.

D'autres méthodes sont basées sur le principe de l'application d'une traction. On peut citer les brevets américains N° 5 783 022 et 5 863 375 qui divulguent l'introduction d'un jet de fluide latéralement alors qu'une traction est exercée sur au moins l'une des plaques, en bord de plaque. Un plot fixé à au moins l'une des plaques permet de tirer sur cette plaque. On peut également citer le document EP-A-0 925 888 divulguant l'ouverture latérale de plaques collées grâce à des flasques saisissant chacune des plaques. Les plaques sont saisies par les flasques par exemple en provoquant un vide entre les plaques. Pour certaines applications, les flasques ont une forme courbe. Chacune des plaques est soumise à une traction en son bord et en sens opposé d'une plaque à l'autre.

Une deuxième approche consiste à introduire en force un coin suivant un axe (ou plusieurs axes) radial ou transverse ou parallèle au plan de collage ou parallèle au plan de fragilisation de la structure collée. Cette technique d'introduction d'un coin peut être considérée comme très proche des techniques basées sur la traction. Le document FR-A-2 823 373 divulgue l'introduction d'une lame sur la périphérie d'une structure empilée. La séparation utilisée permet en particulier un détachement dans une zone fragilisée par exemple par implantation ionique. Cette technique permet notamment d'introduire une lame en forme d'arc de cercle, adapté à la circonférence de plaques à séparer.

Le Fraunhofer Institute a mis au point une méthode permettant l'ouverture en particulier suivant quatre axes pour séparer des structures empilées. Les lames sont introduites suivant quatre axes perpendiculaires. On peut se référer à ce sujet à l'article « A new approach for handling and transferring of thin semiconductor materials » de J. Bagdahn et al. (Microsystem Technologies 9 (2003), pages 204 à 209).

La société Canon K.K. a mis au point un procédé dit « Water Jet » consistant à utiliser un jet d'eau sous haute pression. Injecté latéralement à la structure empilée et parallèlement au plan de la zone poreuse de séparation, ce fluide sous pression permet de séparer les plaques empilées. Ce procédé peut par exemple être utilisé dans le procédé ELTRAN® de réalisation de structures SOI. La séparation est dans ce cas localisée au niveau de la zone poreuse réalisée dans les plaques de silicium au cours de ce procédé.

Un autre exemple est divulgué dans le brevet américain N° 5 985 742. Il comprend l'utilisation d'un jet de fluide sous haute pression. Injecté latéralement à la structure empilée et parallèlement au plan de la zone de séparation, ce fluide sous pression permet de séparer les plaques pour réaliser des structures SOI, SiGe ou autres. La séparation, dans ce cas, est localisée au niveau de la zone sollicitée réalisée au cours de la mise en oeuvre du procédé.

Selon une troisième approche, il est possible de localiser le décollement entre deux plaques d'une structure empilée obtenue par collage. Le document FR-A- 2 796 491 divulgue l'ouverture localisée d'une structure empilée par l'introduction localisée d'une surpression créée entre la zone à séparer et les faces externes de la structure à séparer. Ce document n'enseigne pas la façon de séparer les plaques suivant une courbure mais enseigne plutôt la façon d'introduire un fluide à l'interface de collage en le localisant.

Par ailleurs, le brevet américain N° 6 387 829 divulgue un procédé de fabrication d'un substrat SOI à partir d'un ensemble comprenant un substrat donneur en silicium et un substrat accepteur. Le substrat donneur présente une surface recouverte d'une couche isolante. A une distance déterminée de la surface, ce substrat possède une couche riche en hydrogène. Le substrat accepteur est fixé sur le substrat donneur, côté couche isolante. De l'énergie est appliquée à l'ensemble pour transformer la couche riche en hydrogène en couche continue, ce qui conduit à la séparation de l'ensemble.

Toutes les techniques de l'art antérieur ne parviennent pas à surmonter la difficulté consistant à séparer en deux parties une structure empilée, l'effort appliqué dans une direction transversale par rapport à la structure étant mal adapté, trop important et/ou induisant une fracture indésirable de tout ou partie de la structure.

### EXPOSÉ DE L'INVENTION

L'invention, définie dans la revendication 1, permet de remédier aux inconvénients présentés par les techniques de l'art antérieur.

Le procédé selon l'invention consiste à provoquer l'ouverture (ou décollement ou séparation ou fracture) de la structure empilée en mettant en oeuvre un effort de flexion appliqué à la structure empilée (dite aussi collée et/ou à zone fragilisée). Un des effets de cet effort de flexion est de provoquer la déformation en courbure de tout ou partie de la structure empilée.

L'invention a donc pour objet un procédé de séparation d'au moins deux plaques collées entre elles en formant une structure empilée, caractérisé en ce que la structure empilée est soumise à au moins un effort de flexion appliqué sur tout ou partie de la structure empilée pour séparer la structure empilée en deux parties selon un plan de séparation désiré.

Avantageusement, en plus de l'effort de flexion, la structure empilée est également soumise à un effort dirigé dans la direction du plan de séparation désiré et tendant à séparer les deux parties. A titre d'exemple, l'effort dirigé dans la direction du plan de séparation désiré résulte de l'introduction d'une lame, d'un coin ou d'un jet de fluide dans le plan de séparation ou d'un effort d'ouverture localisée dans le plan de séparation.

L'effort de flexion peut être au moins en partie consécutif au collage des plaques. Il peut résulter du collage des plaques à une température donnée qui provoque une dilatation thermique différentielle des plaques, la séparation se faisant à une température différente de la température de collage. Il peut aussi résulter du collage des plaques sous déformation.

Le plan de séparation peut être constitué par l'interface entre les deux plaques collées.

Le plan de séparation peut aussi être constitué par un plan fragilisé dans l'une des plaques, la séparation fournissant une première partie constituée de l'une des plaques supportant une couche provenant de l'autre plaque, la séparation fournissant également une deuxième partie constituée de l'autre plaque diminuée de ladite couche. Le plan fragilisé peut correspondre à une couche fragilisée induite dans l'une des plaques. Cette couche fragilisée peut être une couche obtenue par implantation ionique.

Le plan fragilisé peut aussi être induit par des contraintes produites dans le volume de l'une des plaques. Il peut consister en une zone préparée spécifiquement dans l'une des plaques, par exemple en rendant poreuse une plaque de silicium au niveau de la zone à séparer.

L'effort de flexion peut être appliqué par l'intermédiaire d'au moins une préforme exerçant une action sur l'une des plaques. Il peut aussi être appliqué selon un cycle d'application de la flexion et de suppression de la flexion.

Des ondes sonores, par exemple des ultrasons peuvent être en outre appliqués à la structure empilée pour faciliter sa séparation.

Les plaques peuvent être collées entre elles avec un contrôle de l'énergie de collage de façon à pouvoir séparer la structure empilée en fonction d'un effort de flexion déterminée. L'énergie de collage peut être contrôlée par contrôle d'au moins l'un des paramètres suivants : la rugosité des surfaces des plaques avant collage, l'hydrophilie de ces surfaces, la température d'un traitement thermique appliqué à la structure empilée.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue partielle d'une structure empilée, permettant d'illustrer le procédé selon l'invention,
- la figure 2 est une vue de côté illustrant un premier cas pratique de mise en oeuvre de l'invention,
- la figure 3 est une vue de côté illustrant un deuxième cas pratique de mise en oeuvre de l'invention,
- la figure 4A est une vue partielle d'une structure empilée obtenue par collage de deux plaques,
- les figures 4B et 4C sont des vues de côté illustrant un troisième cas pratique de mise en oeuvre de l'invention,
- les figures 5A à 5D sont des vues de côté illustrant un quatrième cas pratique de mise en oeuvre de l'invention,
- les figures 6A à 6C sont des vues de côté illustrant un cinquième cas pratique de mise en oeuvre de l'invention,
- les figures 7A à 7C sont des vues de côté illustrant un septième cas pratique de mise en oeuvre de l'invention,
- les figures 8A à 8C sont des vues de côté illustrant un autre mode de mise en oeuvre de l'invention.

### EXPOSÉ DÉTAILLÉ DE MODES DE RÉALISATION PARTICULIERS

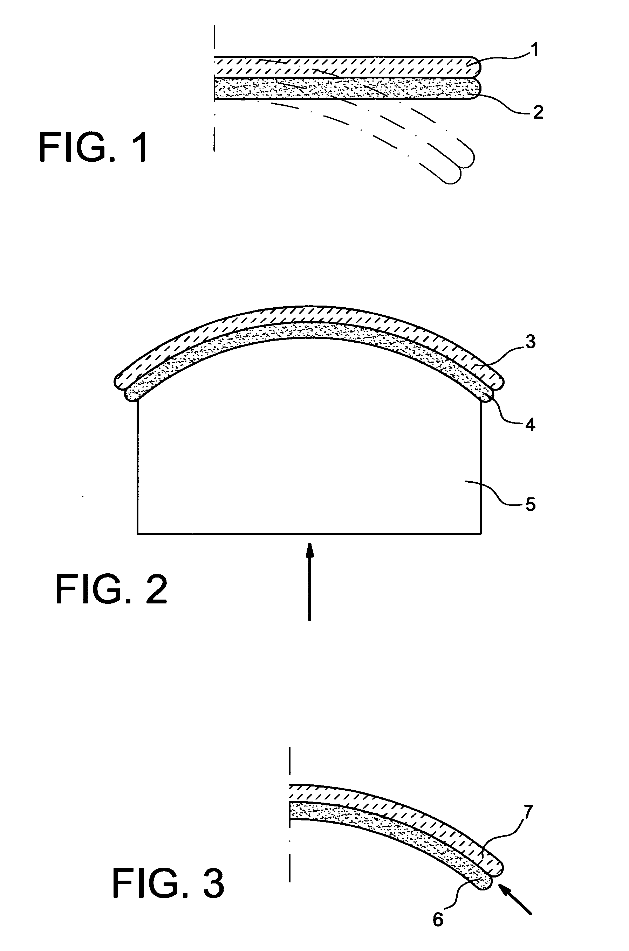

La figure 1 est illustrative du procédé selon l'invention. Elle montre, vue de côté, une structure empilée constituée de deux plaques 1 et 2 collées entre elles. Le collage peut être obtenu par adhésion moléculaire ou par l'intermédiaire d'une substance adhésive.

Un effort de flexion est appliqué tel que son moment soit autour d'un axe perpendiculaire à la direction souhaitée pour l'ouverture de la structure à séparer. Cet axe perpendiculaire et cette direction souhaitée sont préférentiellement contenus dans le plan d'interface de collage ou de la zone fragilisée.

En traits mixtes, on a représenté la structure fléchie avant l'amorce du décollage ou séparation entre les deux lames 1 et 2.

On va maintenant donner des exemples de mise en oeuvre de l'invention sur des cas pratiques.

Le premier cas pratique, représenté à la figure 2, concerne une structure empilée par collage moléculaire, par exemple en mode hydrophile, à température ambiante. Elle est constituée par exemple d'une plaque de silicium 3, de 200 mm de diamètre, collée sur une plaque de verre 4 (ou de silice fondue ou de quartz) de 200 mm de diamètre également. Le collage a été effectué alors que les plaques étaient en position plane.

La séparation est amorcée en appliquant un effort de flexion sur la structure empilée par exemple par un appui du côté de la plaque de verre 4, respectant la symétrie circulaire de la structure collée. C'est ce que montre la figure 2 où la structure est soumise à un effort de flexion par l'intermédiaire d'une préforme 5. La séparation se propage sur toute la surface de la structure à séparer, localisée au niveau de l'interface de collage.

La séparation est favorisée par la différence de raideur des matériaux par exemple. En particulier, cet effort de flexion peut être assisté par un effort transversal appliqué au niveau de l'interface de collage, par exemple pour amorcer la séparation.

La structure empilée peut être maintenue sur la préforme par exemple par aspiration ou par des fixations latérales. Avantageusement, on peut provoquer des cycles d'application de flexion et de suppression de flexion, induisant ainsi une fragilisation de la zone de collage à séparer.

Dans le deuxième cas pratique, la structure à séparer est une hétéro-structure et est empilée par collage moléculaire, par exemple en mode dit hydrophile, à une certaine température, par exemple 80°C. Elle est constituée par exemple d'une plaque de silicium, de diamètre 200 mm, collée sur une plaque de verre (ou de silice fondue ou de quartz, ...) de diamètre 200 mm. En refroidissant à la température ambiante la structure après son collage, celle-ci présente une déformation de flexion homogène se traduisant par une flèche.

La structure refroidie présente alors une forme convexe comme cela est représenté à la figure 3. Dans cet exemple, la plaque 6, par exemple en silicium, est la partie inférieure de la forme convexe et la plaque 7 en verre est la partie supérieure.

La séparation est amorcée en appliquant un effort de flexion sur la plaque inférieure de la structure la rendant ainsi plus ou moins convexe. La séparation se propage sur toute la surface de la structure à séparer, localisée au niveau de l'interface de collage. La séparation est plus ou moins favorisée suivant la raideur des matériaux.

La séparation est favorisée par la différence de dilatation thermique des matériaux de chacune des plaques initiales de la structure empilée. Ainsi, dans une autre structure empilée, constituée d'une plaque de saphir collée sur une plaque de silicium, la forte différence de coefficient de dilatation thermique favorisera le décollement par l'application d'une flexion sur la structure collée.

En particulier, cet effort de flexion peut être assisté, par exemple pour amorcer la séparation, par un effort transversal appliqué au niveau de l'interface de collage, comme schématisé par une flèche sur la figure 3.

Avantageusement, on provoquera des cycles d'application de la flexion et de suppression de la flexion, provoquant ainsi une fragilisation de la zone de collage à séparer.

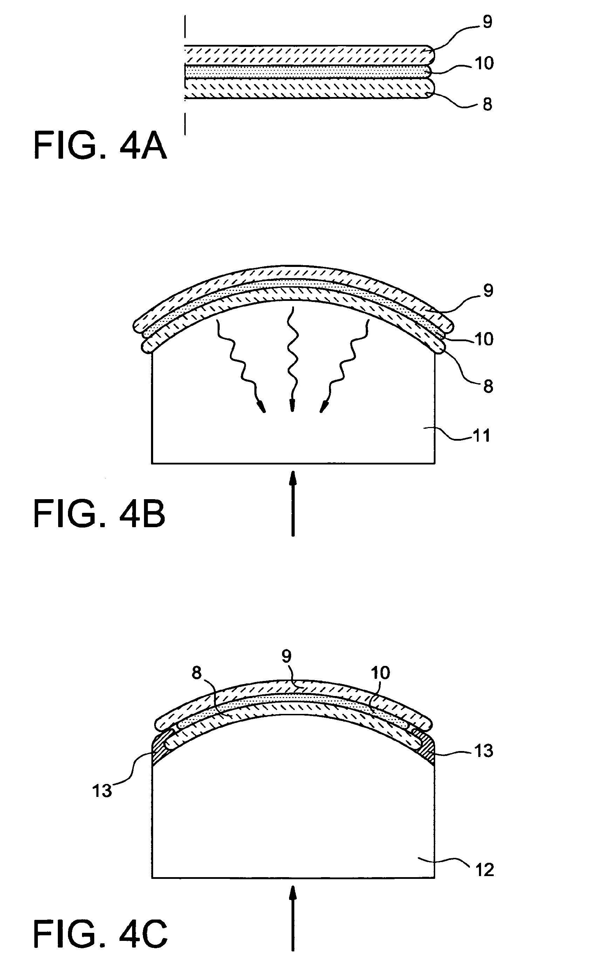

Dans le troisième cas pratique, la structure à séparer est obtenue par collage non moléculaire de deux plaques comme le montre la figure 4A. Elle est constituée d'une plaque de silicium 8, de 200 mm de diamètre, collée sur une plaque de verre 9 de 200 mm de diamètre également. Le collage est réalisée par une substance adhésive 10 telle qu'une colle (par exemple durcissable sous UV, de la cyanolite, ...) une cire, une résine (par exemple une résine Apiezon) ou un métal à bas point de fusion (par exemple du gallium ou un alliage d'étain ou d'indium) ou non. La séparation est amorcée en appliquant un effort de flexion sur la structure la rendant ainsi plus ou moins convexe.

Pour appliquer l'effort de flexion, on utilisera par exemple une préforme correspondant à la forme convexe souhaitée pour la plaque, et on tiendra cette plaque sur cette préforme par exemple par aspiration ou par des fixations latérales.

La figure 4B montre la structure de la figure 4A soumise à un effort de flexion par l'intermédiaire d'une préforme 11 maintenant la plaque 8 par aspiration.

La figure 4C montre une autre façon de faire. La structure de la figure 4A est soumise à un effort de flexion par l'intermédiaire d'une préforme 12 maintenant la plaque 8 au moyen de fixations latérales 13.

Avantageusement, on utilisera des substances adhésives ne supportant pas le cisaillement ou des matériaux de collage induisant des raideurs différentes à l'interface de collage.

En particulier, cet effort de flexion peut être assisté par un effort transversal appliqué au niveau de l'interface de collage.

Avantageusement, on provoquera des cycles d'application de la flexion et de suppression de la flexion, induisant ainsi une fatigue de la zone de collage dans la structure à séparer.

Avantageusement, suivant la nature de la substance adhésive, l'effort de flexion sera assisté par un traitement thermique appliqué avant, pendant ou après le procédé d'ouverture. Il pourra de même être assisté par une irradiation lumineuse par exemple du type UV.

Dans le quatrième cas pratique, on effectue une fragilisation de l'une des deux plaques de la future structure empilée par implantation d'une ou de plusieurs espèces, par exemple des espèces gazeuses telles que l'hydrogène ou l'hélium.

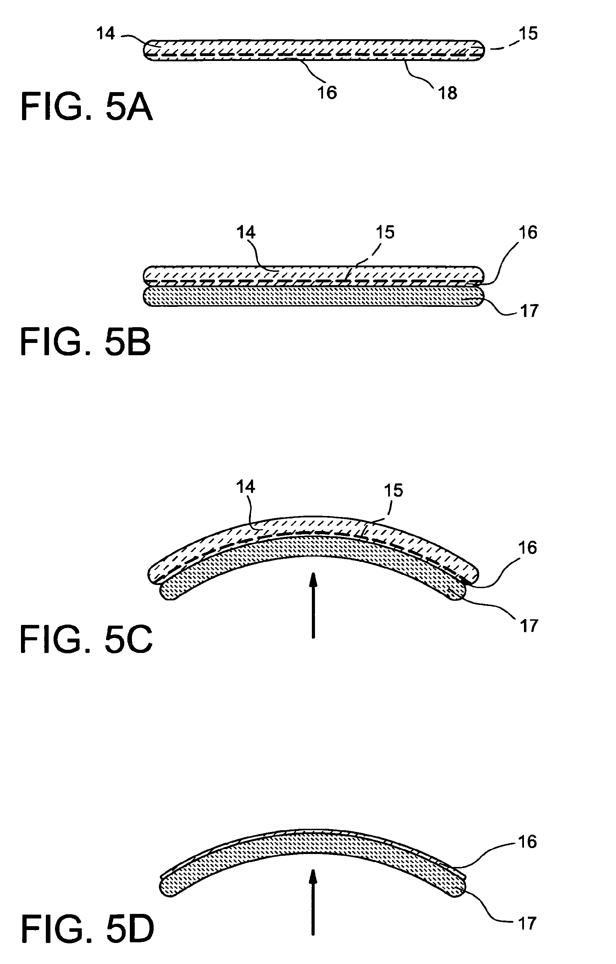

La figure 5A montre une plaque de silicium 14 possédant une couche fragilisée 15 obtenue par implantation d'hydrogène. A titre indicatif, l'implantation peut se faire pour une dose de 6.10¹⁶ atomes/cm² et pour une énergie de 70 keV. La couche fragilisée 15 délimite, par rapport à la face d'implantation 18, une couche mince 16.

La figure 5B représente une structure empilée obtenue par collage moléculaire de la plaque 14 sur une plaque 17 par exemple en verre. Le collage a été effectué de façon que la couche mince 16 se trouve en contact avec la plaque 17.

On soumet ensuite la structure empilée à un traitement thermique, par exemple à 300°C pendant une heure pour induire une fragilisation contrôlée dans la plaque 14, au niveau de la couche fragilisée 15.

Ensuite, une flexion est induite dans la structure 18, soit du côté de la face arrière de la plaque 14 (c'est-à-dire la face opposée à la face d'implantation), soit du côté de la plaque 17. C'est ce que montre la figure 5C. La flexion est poursuivie jusqu'à obtenir la séparation de la structure au niveau de la couche fragilisée 15, fournissant ainsi deux parties distinctes.

Les deux plaques 14 et 17 sont donc séparées l'une de l'autre, la couche mince 16 provenant de la plaque 14 restant fixée sur la plaque 17 qui lui sert de support. La figure 5D montre la plaque 17 recouverte de la couche mince 16 juste après la séparation avec le reste de la plaque 14.

L'effort de flexion peut être assisté par un effort transversal appliqué au niveau de la couche fragilisée, par exemple pour amorcer la séparation. Avantageusement, on provoquera des cycles d'application de flexion et de suppression de flexion, induisant ainsi une fatigue de la couche fragilisée dans la structure à séparer. L'effort de flexion peut aussi être assisté par un traitement thermique appliqué avant, pendant ou après cet effort de flexion.

Selon une variante de réalisation du quatrième cas pratique, la fragilisation contrôlée dans la plaque 14 peut être induite par un traitement thermique (300°C pendant 1 heure) avant le collage de cette plaque sur la plaque 17. De façon concomitante ou non au traitement thermique, cette fragilisation contrôlée peut aussi être induite, partiellement ou en totalité, comme il est connu de l'homme du métier, par l'application d'une contrainte mécanique, par exemple de traction, de flexion, etc. Cette application peut être répétée plusieurs fois.

Dans le cinquième cas pratique, le collage d'une deuxième plaque sur une première plaque est remplacé par une épitaxie réalisée sur une plaque initiale.

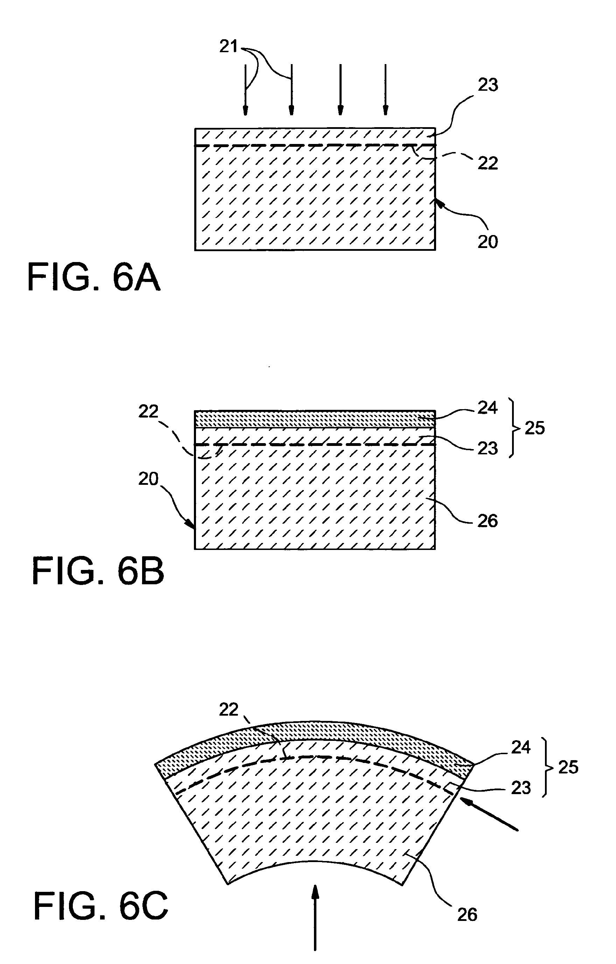

La figure 6A représente une étape d'implantation ionique effectuée au travers d'une face d'une plaque 20 en silicium. L'implantation représentée sous la référence 21, est par exemple réalisée au moyen d'ions hydrogène selon une dose de 6.10¹⁶ atomes/cm² avec une énergie de 70 keV. Elle induit dans la plaque 20 une couche fragilisée 22. Un traitement thermique à 300°C pendant 1 heure induit une fragilisation contrôlée dans la plaque au niveau de la couche fragilisée. Une couche mince 23 est ainsi délimitée entre la face implantée et la couche fragilisée 22.

Une épitaxie est alors réalisée sur la face implantée de la plaque 20, par exemple une épitaxie de silicium de plusieurs micromètres d'épaisseur. On obtient donc une couche épitaxiée 24 sur la couche mince 23, formant ensemble une couche épaisse 25 (voir la figure 6B).

La couche épaisse 25 et le reste 26 de la plaque 20 constituent une structure empilée, la couche fragilisée 22 jouant le rôle d'interface.

Une étape de flexion est alors appliquée à la structure comme le montre la figure 6C jusqu'à obtenir la séparation de la structure en deux parties de part et d'autre de la couche fragilisée 22. La séparation peut être assistée par un effort transversal appliqué au niveau de la couche fragilisée comme le montre la flèche située à droite de la figure 6C.

Dans le sixième cas pratique, la structure est empilée par collage moléculaire, par exemple en mode dit hydrophile, en utilisant des surfaces volontairement rendues rugueuses. Elle est constituée par exemple d'une plaque de silicium oxydé, de diamètre 200 mm, collée sur une plaque de silicium oxydé de diamètre 200 mm.

Les films d'oxyde sont rendus rugueux avant collage par attaque chimique de HF à 49%, pour obtenir par exemple une rugosité de 0,6 nm (valeur RMS). L'énergie de collage de la structure empilée obtenue est étroitement liée à cette rugosité. Elle est d'autant plus faible que la rugosité est forte.

La séparation est amorcée en appliquant un effort de flexion sur la structure empilée respectant la symétrie circulaire de la structure collée. La séparation se propage sur toute la surface de la structure à séparer, localisée au niveau de l'interface de collage. En particulier, cet effort de flexion peut être assisté par un effort transversal appliqué au niveau de l'interface de collage.

Pour appliquer l'effort de flexion, on utilisera par exemple une préforme concave correspondant à la flexion souhaitée pour la structure, et on maintiendra la structure sur cette préforme par exemple par aspiration ou par des fixations latérales.

Avantageusement, on provoquera des cycles d'application de la flexion et de suppression de la flexion, provoquant ainsi une fragilisation de la zone de collage à séparer.

Dans une alternative de l'exemple précédent, au lieu de contrôler la rugosité des surfaces obtenues par attaque chimique, on peut contrôler le caractère hydrophile des surfaces avant le collage. L'énergie de collage de la structure empilée est également liée à cette hydrophilie. La séparation est amorcée en appliquant un effort de flexion sur la structure empilée. En particulier, cet effort de flexion peut être assisté par un effort transversal appliqué au niveau de l'interface de collage.

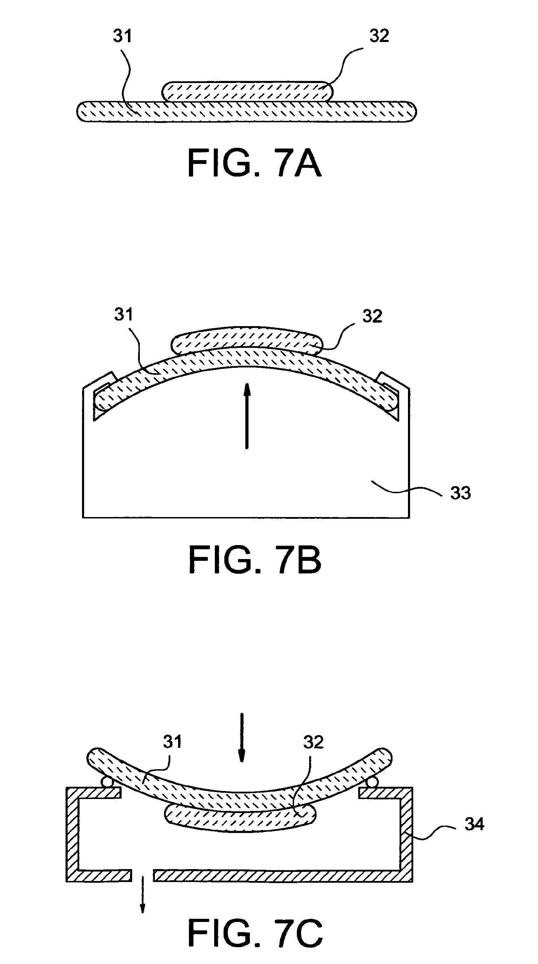

Dans le septième cas pratique, la structure empilée est constituée de plaques de diamètres différents. Ainsi, la figure 7A montre une plaque de grand diamètre 31 collée à une plaque de petit diamètre 32. Le collage est par exemple du type moléculaire.

La plus grande des deux plaques permet alors la tenue de la structure à décoller pendant l'application de la flexion. Les figures 7B et 7C illustrent deux variantes d'application d'une flexion à cette structure.

La figure 7B montre la structure empilée disposée sur une préforme 33 qui permet la tenue de la plaque 31 et la flexion, par application d'une poussée verticale, de la structure à décoller.

La figure 7C montre la structure empilée disposée sur un dispositif à dépression 34. La grande plaque 31 bouche la cavité du dispositif à dépression 34, la petite plaque 32 étant alors située vers l'intérieur du dispositif. Une dépression (ou le vide) est produite dans le dispositif 34, ce qui provoque la flexion de la structure vers l'intérieur du dispositif et ce qui entraîne la séparation des plaques.

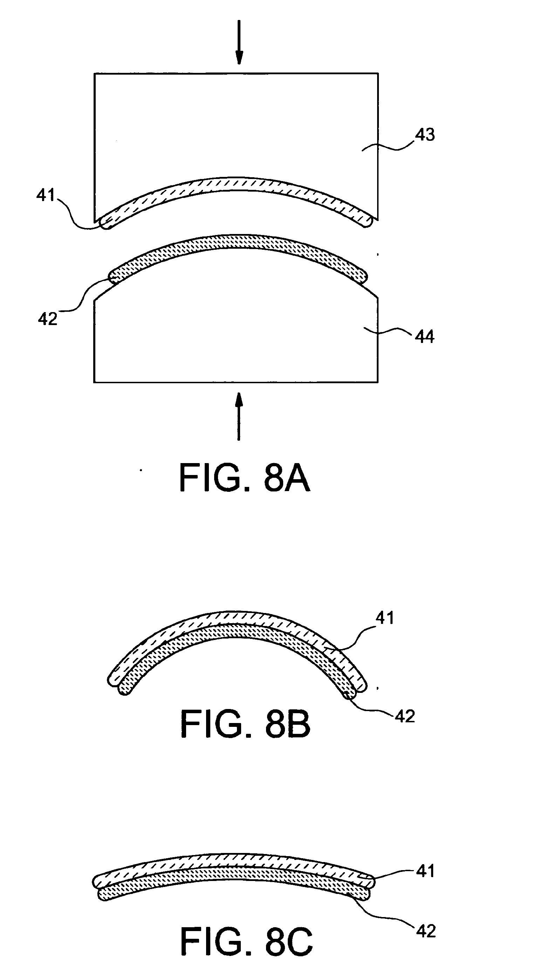

Pour tous les exemples donnés ci-dessus, on peut également procéder de la manière suivante. La structure empilée peut être réalisée de manière à être initialement déjà fléchie. Cette déformation initiale peut être induite lors du collage des plaques et/ou lors d'étapes supplémentaires subies par la structure à séparer, par exemple pendant des étapes de procédé de réalisation de composants pour la micro-électronique. Le procédé selon l'invention peut alors consister à imposer une mise à plat ou une autre flexion contrôlée de la structure. Cette mise en oeuvre du procédé est illustrée par les figures 8A à 8C.

La figure 8A montre deux plaques 41 et 42 au cours d'une étape de collage, par exemple au cours d'une étape de collage par adhésion moléculaire. Le collage est réalisé alors que les plaques 41 et 42 sont pressées entre deux préformes de collage 43 et 44 de formes complémentaires, ce qui fournit une structure empilée de forme fléchie.

La séparation de la structure peut être obtenue en augmentant la flexion de la structure empilée (voir la figure 8B) ou en diminuant la flexion de la structure empilée (voir la figure 8C) jusqu'à obtenir la séparation. La séparation peut résulter aussi de cycles d'augmentation et de diminution de la flexion.

Le procédé selon l'invention peut être mis en oeuvre en utilisant une membrane pour la mise en flexion de la structure à décoller ou à fracturer. Il peut aussi être mis en oeuvre en utilisant un moule plat avec aspiration.

## Revendications

1. Procédé de séparation d'au moins deux plaques (1, 2) collées entre elles en formant une structure empilée, **caractérisé en ce que** la structure empilée est soumise à au moins un effort de flexion appliqué sur tout ou partie de la structure empilée en provoquant la déformation en courbure de la structure empilée pour séparer la structure empilée en deux parties selon un plan de séparation désiré.

2. Procédé selon la revendication 1, **caractérisé en ce que**, en plus de l'effort de flexion, la structure empilée est également soumise à un effort dirigé dans la direction du plan de séparation désiré et tendant à séparer les deux parties.

3. Procédé selon la revendication 2, **caractérisé en ce que** l'effort dirigé dans la direction du plan de séparation désiré résulte de l'introduction d'une lame, d'un coin ou d'un jet de fluide dans le plan de séparation ou d'un effort d'ouverture localisée dans le plan de séparation.

4. Procédé selon la revendication 1, **caractérisé en ce que** l'effort de flexion est au moins en partie consécutif au collage des plaques.

5. Procédé selon la revendication 4, **caractérisé en ce que** l'effort de flexion consécutif au collage des plaques résulte du collage des plaques à une température donnée qui provoque une dilatation thermique différentielle des plaques, la séparation se faisant à une température différente de la température de collage.

6. Procédé selon la revendication 4, **caractérisé en ce que** l'effort de flexion consécutif au collage des plaques résulte du collage des plaques (41, 42) sous déformation.

7. Procédé selon la revendication 1, **caractérisé en ce que** le plan de séparation est constitué par l'interface entre les deux plaques collées (1, 2).

8. Procédé selon la revendication 1, **caractérisé en ce que** le plan de séparation est constitué par un plan fragilisé dans l'une des plaques, la séparation fournissant une première partie constituée de l'une des plaques (17) supportant une couche (16) provenant de l'autre plaque (14), la séparation fournissant également une deuxième partie constituée de l'autre plaque diminuée de ladite couche.

9. Procédé selon la revendication 8, **caractérisé en ce que** le plan fragilisé correspond à une couche fragilisée (15) induite dans l'une des plaques.

10. Procédé selon la revendication 9, **caractérisé en ce que** la couche fragilisée (15) est une couche obtenue par implantation ionique.

11. Procédé selon la revendication 8, **caractérisé en ce que** le plan fragilisé est induit par des contraintes produites dans le volume de l'une des plaques.

12. Procédé selon la revendication 1, **caractérisé en ce que** l'effort de flexion est appliqué par l'intermédiaire d'au moins une préforme (5) exerçant une action sur l'une (4) des plaques.

13. Procédé selon la revendication 1, **caractérisé en ce que** l'effort de flexion est appliqué selon un cycle d'application de la flexion et de suppression de la flexion.

14. Procédé selon la revendication 1, **caractérisé en ce que** des ondes sonores sont en outre appliqués à la structure empilée pour faciliter sa séparation.

15. Procédé selon la revendication 1, **caractérisé en ce que** les plaques sont collées entre elles avec un contrôle de l'énergie de collage de façon à pouvoir séparer la structure empilée en fonction d'un effort de flexion déterminée.

16. Procédé selon la revendication 15, **caractérisé en ce que** l'énergie de collage est contrôlée par contrôle d'au moins l'un des paramètres suivants: la rugosité des surfaces des plaques avant collage, l'hydrophilie de ces surfaces, la température d'un traitement thermique appliqué à la structure empilée.

## Claims

1. Method for separating at least two wafers (1, 2) bonded together to form a stacked structure, **characterized in that** the stacked structure is subjected to at least one bending force applied to all or part of the stacked structure whilst causing the curved deformation thereof in order to separate said stacked structure into two parts, along a required separation plane.

2. Method according to claim 1, **characterized in that** in addition to the bending force, the stacked structure is also subjected to a force along the direction of the required separation plane, and tending to separate the two parts.

3. Method according to claim 2, **characterized in that** the force along the direction of the required separation plane is created by inserting a blade, a wedge or a fluid jet in the separation plane, or by applying an opening force localized in the separation plane.

4. Method according to claim 1, **characterized in that** the bending force is at least partly applied after the wafers have been bonded.

5. Method according to claim 4, **characterized in that** the bending force applied after the wafers have been bonded is the result of bonding of the wafers at a given temperature that causes a differential thermal expansion of the wafers, the separation taking place at a temperature different from the bonding temperature.

6. Method according to claim 4, **characterised in that** the bending force applied after the wafers have been bonded is the result of bonding of wafers (41, 42) under deformation.

7. Method according to claim 1, **characterised in that** the separation plane is composed of the interface between the two bonded wafers (1, 2).

8. Method according to claim 1, **characterised in that** the separation plane consists of a weakened plane in one of the wafers, the separation providing a first part composed of one of the wafers (17) supporting a layer (16) originating from the other wafer (14), the separation also resulting in a second part composed of the other wafer without the said layer.

9. Method according to claim 8, **characterised in that** the weakened plane corresponds to a weakened layer (15) induced in one of the wafers.

10. Method according to claim 9, **characterised in that** the weakened layer (15) is a layer obtained by ionic implantation.

11. Method according to claim 8, **characterised in that** the weakened plane is induced by stresses produced in the volume of one of the wafers.

12. Method according to claim 1, **characterised in that** the bending force is applied using at least one preform (5) applying an action on one (4) of the wafers.

13. Method according to claim 1, **characterised in that** the bending force is applied using a bending application and bending removal cycle.

14. Method according to claim 1, **characterised in that** sound waves are also applied to the stacked structure to facilitate its separation.

15. Method according to claim 1, **characterised in that** the wafers are bonded together while controlling the bonding energy so as to be able to separate the stacked structure as a function of a determined bending force.

16. Method according to claim 15, **characterised in that** the bonding energy is controlled by controlling at least one of the following parameters: surface roughness of the wafers before bonding, the hydrophilic nature of these surfaces, the temperature of a heat treatment applied to the stacked structure.

## Patentansprüche

1. Verfahren zum Trennen von wenigstens zwei Platten (1, 2), die so aufeinandergeklebt sind, dass sie eine Stapelstruktur bilden,
**dadurch gekennzeichnet, dass** die Stapelstruktur wenigstens einer Biegebelastung unterzogen wird, die auf die Gesamtheit oder einen Teil der Stapelstruktur angewendet wird, um eine Biegeverformung der Stapelstruktur zu bewirken, welche die Stapelstruktur entsprechend einer gewünschten Ebene in zwei Teile trennt.

2. Verfahren nach Anspruch 1, **dadurch gekennzeichnet, dass** die Stapelstruktur zusätzlich zu der Biegebelastung auch einer Belastung unterzogen wird, die entsprechend der Richtung der gewünschten Trennungsebene ausgerichtet ist und dazu tendiert, die beiden Teile zu trennen.

3. Verfahren nach Anspruch 2, **dadurch gekennzeichnet, dass** die entsprechend der Richtung der gewünschten Trennungsebene ausgerichtete Belastung aus dem Eindringen einer Schneide, eines Keils oder eines Fluidstrahls in die Trennungsebene oder aus der Kraftaufwendung für eine lokalisisrto Öffnung in der Trennungsebene resultiert.

4. Verfahren nach Anspruch 1, **dadurch gekennzeichnet, dass** die Biegebelastung wenigstens zum Teil eine Folge des Aufeinanderklebens der Platten ist.

5. Verfahren nach Anspruch 4, **dadurch gekennzeichnet, dass** die durch das Aufeinanderkleben der Platten verursachte Biegebelastung aus dem Aufeinanderkleben der Platten bei einer bestimmten Temperatur, die eine unterschiedliche Wärmedehnung der Platten bewirkt, resultiert und die Trennung dann bei einer anderen Temperatur als der Klebungstemperatur erfolgt.

6. Verfahren nach Anspruch 4, **dadurch gekennzeichnet, dass** die auf dem Aufeinanderkleben der Platten beruhende Biegebelastung aus dem Aufeinanderkleben der Platten (41, 42) unter Verformung resultiert.

7. Verfahren nach Anspruch 1, **dadurch gekennzeichnet, dass** die Trennungsebene durch die Grenzfläche zwischen den beiden aufeinandergeklebten Platten (1, 2) gebildet wird.

8. Verfahren nach Anspruch 1, **dadurch gekennzeichnet, dass** die Trennungsebene durch eine geschwächte Ebene in einer der beiden Platten gebildet wird, wobei die Trennung einen ersten Teil liefert, der durch eine der Platten (17) gebildet wird und eine von der anderen Platte (14) gelieferte Schicht (16) trägt, und ebenfalls einen zweiten Teil liefert, gebildet durch die um die genannte Schicht reduzierte andere Platte.

9. Verfahren nach Anspruch 8, **dadurch gekennzeichnet, dass** die geschwächte Ebene einer in einer der Platten realisierten geschwächten Schicht (15) entspricht.

10. Verfahren nach Anspruch 9, **dadurch gekennzeichnet, dass** die geschwächte Ebene (15) eine durch lonenimplantation realisierte Ebene ist.

11. Verfahren nach Anspruch 8, **dadurch gekennzeichnet, dass** die geschwächte Ebene durch die in dem Volumen von einer der Platten erzeugten Spannungen realisiert wird.

12. Verfahren nach Anspruch 1, **dadurch gekennzeichnet, dass** die Biegebelastung mittels wenigstens einer Vorform (5) angewendet wird, die auf eine der Platten (4) einwirkt.

13. Verfahren nach Anspruch 1, **dadurch gekennzeichnet, dass** die Biegebelastung entsprechend einem Biegunganwendungs- und Biegungweglassungszyklus ausgeübt wird.

14. Verfahren nach Anspruch 1, **dadurch gekennzeichnet, dass** außerdem Schallwellen auf die Stapelstruktur angewendet werden, um ihre Trennung zu erleichtern.

15. Verfahren nach Anspruch 1, **dadurch gekennzeichnet, dass** die Platten mit einer Kontrolle der Klebungsenergie aufeinandergeklebt werden, um die Stapelstruktur in Abhängigkeit von einer bestimmten Biegebelastung trennen zu können.

16. Verfahren nach Anspruch 15, **dadurch gekennzeichnet, dass** die Klebungsenergie durch die Kontrolle wenigstens eines der folgenden Parameter kontrolliert wird: die Rauheit der Oberflächen der Platten vor der Klebung, die Saugfähigkeit ihrer Oberflächen, die Temperatur einer auf die Stapelstruktur angewendeten Wärmebehandlung.
